(19) Europäisches Patentamt
European Patent Office
Office européen des brevets

(11) Veröffentlichungsnummer: 0 363 776 A2

# (12) EUROPÄISCHE PATENTANMELDUNG

(21) Anmeldenummer: 89118229.7

(51) Int. Cl.5: G03F 7/105

(22) Anmeldetag: 02.10.89

(30) Priorität: 08.10.88 DE 3834300

(43) Veröffentlichungstag der Anmeldung: 18.04.90 Patentblatt 90/16

(84) Benannte Vertragsstaaten: DE FR GB IT NL

(71) Anmelder: HOECHST AKTIENGESELLSCHAFT
Postfach 80 03 20
D-6230 Frankfurt am Main 80(DE)

(72) Erfinder: Elsässer, Andreas, Dr., Dipl.-Chem.
Hertastrasse 1B
D-6270 Idstein(DE)
Erfinder: Gaschler, Otfried, Dipl.-Ing.
Lilienthalstrasse 19
D-6200 Wiesbaden(DE)
Erfinder: Mohr, Dieter, Dr. Dipl.-Chem.
Eaubonner Strasse 8
D-6501 Budenheim(DE)

## (54) Strahlungsempfindliches Gemisch und hiermit hergestelltes strahlungsempfindliches Kopiermaterial.

(57) Die Erfindung betrifft ein strahlungs- bzw. lichtempfindliches Gemisch und ein hiermit hergestelltes strahlungsempfindliches Kopiermaterial, das im wesentlichen, folgende Bestandteile

A) ein 1,2-Chinondiazid und/oder eine Kombination aus
 1. einer bei Belichtung eine starke Säure bildenden Verbindung und
 2. einer Verbindung mit mindestens einer durch Säure spaltbaren C-O-C-Bindung

B) ein wasserunlösliches, in wäßrig-alkalischen Lösungen lösliches Bindemittel und

C) ein Spiro-Indolino-Benzopyran der allgemeinen Formel I

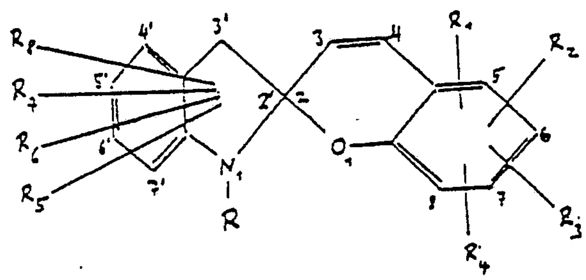

enthält, worin

R ein Wasserstoffatom oder einen Alkylrest mit 1 bis 16 Kohlenstoffatomen,

$R_1$, $R_2$, $R_3$ und $R_4$ gleich oder verschieden sind und Wasserstoff-oder Halogenatome, Alkyl- oder Alkoxygruppen, mit 1 bis 4 Kohlenstoffatomen, Hydroxy- oder Nitrogruppen, und

$R_5$, $R_6$, $R_7$ und $R_8$ gleich oder verschieden sind und Wasserstoff-oder Halogenatome, Nitro-, Aminogruppen, Alkyl-, Alkoxy- oder Hydroxyalkylgruppen mit 1 bis 5 Kohlenstoffatomen oder Arylgruppen mit 6 bis 10 Kohlenstoffatomen

bedeuten.

Das Gemisch ergibt bei Bestrahlung einen starken Farbkontrast, der auch bei höheren Temperaturen erhalten bleibt.

EP 0 363 776 A2

## Strahlungsempfindliches Gemisch und hiermit hergestelltes strahlungsempfindliches Kopiermaterial

Die Erfindung betrifft ein strahlungs- bzw. lichtempfindliches Gemisch, das als wesentliche Bestandteile

A) ein 1,2-Chinondiazid und/oder eine Kombination aus

1. einer unter Einwirkung von aktinischer Strahlung eine starke Säure bildenden Verbindung und
2. einer Verbindung mit mindestens einer spaltbaren C-O-C-Bindung, deren Löslichkeit in einem flüssigen Entwickler durch Einwirkung von Säure erhöht wird, und

B) ein in Wasser unlösliches, in wäßrig-alkalischen Lösungen lösliches polymeres Bindemittel und

C) einen Farbstoff enthält, sowie ein strahlungsempfindliches Kopiermaterial aus einem Schichtträger und einer aufgebrachten Schicht, die dieses Gemisch enthält.

Strahlungs- bzw. lichtempfindliche Gemische aus den genannten Bestandteilen sind bekannt und es sind vielfältige Anwendungsmöglichkeiten, z.B. zur Herstellung von Photoresists oder Flachdruckplatten, beschrieben.

Die in den bekannten Gemischen enthaltenen Farbstoffe genügen im allgemeinen zweierlei Anforderungen: zum einen soll sich nach dem bildmäßigen Bestrahlen der das Gemisch enthaltenden Schicht ein deutlich sichtbarer Kontrast zwischen belichteten und unbelichteten Bereichen einstellen und zum anderen soll sich das nach dem Entwicklungsprozeß verbleibende Reliefbild farblich deutlich vom Schichtträger abheben.

Beides wird erreicht, wenn als Farbstoffe - wie in DE-OS 1 447 022, entsprechend GB-PS 1 041 463 beschrieben - Indikatoren eingesetzt werden, die durch den beim Bestrahlen der Schicht erfolgenden pH-Umschlag eine farbliche Veränderung erfahren. Als geeignete Indikatoren haben sich insbesondere kationische Farbstoffe erwiesen wie z.B. Triarylmethan-, Acridin-, Azin-, Oxazin-, Thiazin- oder Cyaninfarbstoffe. Diese Farbstoffe ergeben im allgemeinen bereits in kleinen Mengen einen intensiven Belichtungskontrast.

Ein Nachteil ergibt sich jedoch aus der Tatsache, daß die Werte für den pH-Umschlag relativ weit im sauren Bereich liegen. Dadurch sind diese Farbstoffe nur bedingt in solchen Gemischen verwendbar, die durch Anwesenheit größerer Mengen puffernder Substanzen bei Belichtung nur verhältnismäßig geringe pH-Wertverschiebungen erfahren.

Bei Gemischen auf Basis von 1,2-Chinondiaziden ist dies z.B. dann der Fall, wenn sie Amine oder vergleichbar stark basische Komponenten enthalten, um einen breiten Verarbeitungsspielraum bei der Positiv-Negativ-Konversion zu ermöglichen. Bei Gemischen auf Basis säurespaltbarer C-O-C-Bindungen übt häufig gerade die spaltbare Einheit durch die bei Bestrahlung erfolgende primäre Ausbildung von Oxoniumionen einen stark puffernden Effekt aus. In diesen Fällen haben sich als geeignete Kontrastbildner Azofarbstoffe - wie z.B. in DE-OS 3 144 480 beschrieben-oder, speziell im Fall von Gemischen auf Basis säurespaltbarer Verbindungen, Hemioxonolfarbstoffe, wie in DE-OS 3 541 534 aufgeführt, erwiesen.

Auch die thermische Stabilität des Belichtungskontrastes ist bei den beschriebenen Farbstoffen - mit Ausnahme der Hemioxonolfarbstoffe, die aber wiederum die Haltbarkeit des Gemisches erheblich beeinträchtigen - unbefriedigend.

Bei der Positiv-Negativ-Konversion von Gemischen auf Basis von 1,2-Chinondiaziden werden Temperaturen bis zu 150 °C angewendet. Gemische auf Basis von säurespaltbaren C-O-C-Bindungen werden bevorzugt nach oder während der Bestrahlung auf Temperaturen bis zu 100 °C erhitzt, um die Vollständigkeit der Spaltreaktion zu gewährleisten. Häufig wird eine bei diesen Gemischen mögliche Zweitbelichtung nach der Erwärmung durchgeführt. Um hierbei die Gefahr von Fehlkopien möglichst auszuschließen, ist es daher von großer Bedeutung, daß der bei der Erstbelichtung hervorgerufene Bildkontrast durch die Erwärmung nicht verändert wird.

Aufgabe der Erfindung war es, ein strahlungsempfindliches Gemisch der eingangs beschriebenen Art zu schaffen, welches auch im Fall eines Gemisches, das puffernde Substanzen enthält, einen starken Bildkontrast bei Bestrahlung ergibt, der eine den praktischen Anforderungen genügende thermische Stabilität aufweist und sonstige Eigenschaften des Gemisches - wie etwa Haltbarkeit - nicht beeinträchtigt.

Die Lösung geht von einem strahlungsempfindlichen Gemisch der eingangs genannten Art aus und sie ist dadurch gekennzeichnet, daß das Gemisch als Farbstoff ein Spiroindolino-benzopyran der allgemeinen Formel I

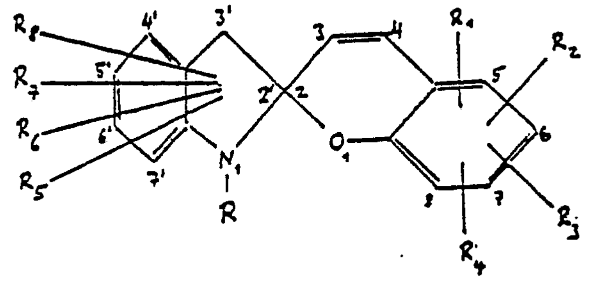

enthält, worin
R ein Wasserstoff oder einen Alkylrest mit 1 bis 16 Kohlenstoffatomen,
$R_1$, $R_2$, $R_3$ und $R_4$ gleich oder verschieden sind und Wasserstoff-oder Halogenatome, Alkyl- oder Alkoxygruppen, mit 1 bis 4 Kohlenstoffatomen, Hydroxy- oder Nitrogruppen, und
$R_5$, $R_6$, $R_7$ und $R_8$ gleich oder verschieden sind und Wasserstoff-oder Halogenatome, Nitro-, Aminogruppen, Alkyl-, Alkoxy- oder Hydroxyalkylgruppen mit 1 bis 5 Kohlenstoffatomen oder Arylgruppen mit 6 bis 10 Kohlenstoffatomen
bedeuten.

Von den Spiro-[2H-1-benzopyran-2,2′-indolinen] der Formel I können in den erfindungsgemäßen strahlungsempfindlichen Gemischen sowohl Derivate, die am Benzopyranringsystem als auch solche, die am Indolinsystem substituiert sind, Anwendung finden.

Geeignete substituierte Benzopyrane sind:
6-Acetyl-, 5-Brom-8-methoxy-6-nitro-, 5-Brom-6-nitro-, 6-Brom-5-nitro-, 8-Brom-6-nitro-, 6-Chlor-, 7-Chlor-, 6-Chlor-5,7-dimethyl-8-nitro-, 8-Chlor-5,6-dinitro-, 5-Chlor-6-nitro-, 5-Chlor-8-nitro-, 6-Cyano-, 5,7-Dichlor-6-nitro-, 6,8-Dichlor-5-nitro-, 5,7-Dimethoxy-6-nitro-, 8-Fluor-, 6-Fluor-8-nitro-, 8-Fluor-6-nitro-, 7-Hydroxy-, 6-Jod-8-nitro-, 8-Jod-6-nitro-, 7-Methoxy-5-methyl-6-nitro-, 6-Methoxy-5-nitro-, 8-Methoxy-5-nitro-, 8-Methoxy-6-nitro-, 5-Nitro-, 6-Nitro-, 7-Nitro-, 8-Nitro-, 6-Nitro-5,7,8-trimethyl-, 6-(ß-Nitrovinyl)-und 7-Methyl-benzopyran.

Als substituierte Indoline kommen die folgenden Verbindungen in Frage:
1′-Butyl-, 3′,3′-Diethyl-, 3′,3′-Diphenyl-, 3′,7′-Diphenyl-, 3′-Ethyl-, 1′-Hexadecyl-, 1′-Isoamyl-, 5′-Nitro-3′-phenyl-, 3′-Phenyl-, 1′,3′,3′-Trimethyl-, 4′-Chlor-, 5′-Chlor=, 6′-Chlor-, 5′,7′-Dichlor-, 1′,3′,3′-Trimethyl-5′-chlor-, 4′,6′-Dimethoxy-, 4′,7′-Dimethyl-, 5′,7′-Dimethyl-, 4′,6′-Diphenyl-, 5′,7′-Diphenyl-, 4′-Fluor-, 5′-Fluor-, 5′-(ß-Hydroxyethyl), 5′-Methoxy-, 7′-Methoxy-, 5′-Methyl-, 6′-Methyl-, 7′-Methyl-, 5′-Nitro-, 7′-Nitro-, 5′-Phenyl-, 7′-Phenyl- und 4′,6′,7′-Triphenyl-indolin.

Wenn einer oder mehrere der Reste $R_1$ bis $R_8$ Alkylgruppen sind, haben diese bevorzugt 1 oder 2 Kohlenstoffatome; Methylgruppen werden besonders bevorzugt. R ist bevorzugt eine Alkylgruppe, insbesondere eine mit 1 bis 5 Kohlenstoffatomen, wobei die Methylgruppe besonders bevorzugt ist. Vorteilhaft enthält das Gemisch eine Verbindung nach Formel I, worin drei der Reste $R_5$, $R_6$, $R_7$ und $R_8$ Methylgruppen sind.

Verbindungen der Formel I, die mindestens eine Nitrogruppe enthalten, die insbesondere im Benzopyransystem steht, geben besonders starke Farbkontraste. Das Gemisch enthält deshalb vorzugsweise eine Verbindung nach der allgemeinen Formel I, worin mindestens einer der Reste $R_1$, $R_2$, $R_3$ und $R_4$ eine Nitrogruppe ist.

Zu den geeigneten Spiro-[2H-1-benzopyran-2,2′-indolinen] zählen vorzugsweise solche, die - entsprechend den oben zusammengestellten, grundsätzlich möglichen Substituenten - an beiden Ringsystemen substituiert sind. Besonders hervorzuheben sind die substituierten Verbindungen, die am Indolinsystem in den Positionen 1′ einmal und 3′ zweimal durch Methylgruppen sowie in Position 6 am Benzopyransystem durch eine Nitrogruppe und gegebenenfalls zusätzlich in Position 8 durch eine Alkoxygruppe, insbesondere eine Methoxygruppe, substituiert sind.

Spiro-indoline-benzopyrane sind bekannt und in "Photochronism" von G.H. Brown, Wiley-Interscience, New York (1971), S. 165-169, insbesondere S. 169, beschrieben. Hieraus sind weitere geeignete Verbindungen zu entnehmen.

Der Mengenanteil an der Verbindung der Formel I am Feststoffgehalt des strahlungsempfindlichen Gemischs liegt im allgemeinen zwischen 0,01 und 10 Gewichtsprozent. Dient der Zusatz ausschließlich zur Erreicherung eines thermisch stabilen Belichtungskontrastes, sind eher kleine Mengen ausreichend; soll der Zusatz aber gleichzeitig einen breiten Verarbeitungsspielraum bei der Bildumkehr ermöglichen, so liegt die einzusetzende Menge im oberen Teil des angegebenen Bereichs.

In einer bevorzugten Ausführungsform der Erfindung verwendet man zusätzlich zum Spiroindolinobenzopyran einen zweiten, kationischen Farbstoff, wie einen Triarylmethan-, Acridin-, Azin-, Oxazin-, Thiazin- oder Cyaninfarbstoff. Der Anteil liegt hierbei ebenfalls zwischen 0,01 und 10 Gewichtsprozent, bezogen auf den Gesamtfeststoff.

Als 1,2-Chinondiazide werden bevorzugt 1,2-Naphthochinondiazid-(2)-4- oder -5-sulfonsäureester oder -amide verwendet. Geeignete Verbindungen dieser Art sind bekannt und zum Beispiel in DE-C 938 233, entsprechend GB-PS 739 654, und DE-A 25 47 905, entsprechend GB-PS 1 561 438 beschrieben.

Die Menge von 1,2-Chinondiazidverbindungen beträgt im allgemeinen 3 bis 50, bevorzugt 7 bis 35 Gewichtsprozent, bezogen auf Gesamtfeststoff des Gemisches.

Als durch Säure spaltbare Verbindungen sind in erster Linie zu nennen:

a) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,

b) Oligomer- oder Polymerverbindungen mit wiederkehrenden Acetal- und/oder Ketalgruppierungen in der Hauptkette und

c) Verbindungen mit mindestens einer Enolether- oder N-Acylaminocarbonatgruppierung.

Durch Säure spaltbare Verbindungen des Typs a) als Komponenten strahlungsempfindlicher Gemische sind in der EP-OS 0 022 571, entsprechend US-PS 4 311 782, ausführlich beschrieben; Gemische, die Verbindungen des Typs b) enthalten, sind in der DE-PS 23 06 248, entsprechend US-PS 3 779 778 beschrieben; Verbindungen des Typs c) werden in EP-OS 0 006 627, entsprechend US-PS 4 248 957 beschrieben.

Als lichtempfindliche Komponenten, die beim Belichten starke Säuren bilden, sind eine große Anzahl von bekannten Verbindungen und Mischungen, wie Phosphonium-, Sulfonium- und Jodoniumsalze, Halogenverbindungen und Organometall-Organohalogen-Kombinationen geeignet.

Die genannten Phosphonium-, Sulfonium-und Jodoniumverbindungen werden in der Regel eingesetzt in Form ihrer in organischen Lösemitteln löslichen Salze, meist als Abscheidungsprodukt mit komplexen Säuren wie Borfluorwasserstoffsäure, Hexafluorphosphor-, Hexafluorantimon-und -arsensäure.

Grundsätzlich sind als halogenhaltige lichtempfindliche und Halogenwasserstoffsäure bildende Verbindungen alle auch als photochemische Radikalstarter bekannten organischen Halogenverbindungen, beispielsweise solche mit mindestens einem Halogenatom an einem Kohlenstoffatom oder an einem aromatischen Ring brauchbar (US-PS 3 515 552, 3 536 489 und 3 779 778). Von diesen Verbindungen werden die s-Triazinderivate mit Halogenmethylgruppen, insbesondere Trichlormethylgruppen, und mit einem aromatischen bzw. ungesättigten Substituenten im Triazinkern, wie sie in DE-PS 27 18 259, entsprechend US-PS 4 189 323, und 33 37 024, entsprechend US-PS 4 619 998, beschrieben sind, bevorzugt. Ebenso geeignet sind 2-Trichlormethyl-1,3,4-oxdiazole (DE-A 28 51 471, entsprechend US-PS 4 212 970). Die Wirkung dieser halogenhaltigen Verbindungen kann auch durch bekannte Sensibilisatoren spektral beeinflußt und gesteigert werden.

Beispiele für geeignete photochemische Säurespender sind:

4-Methyl-6-trichlormethyl-2-pyron, 4-(3,4,5-Trimethoxystyryl)-6-trichlormethyl-2-pyron, 4-(4-Methoxy-styryl)-6-(3,3,3-trichlorpropenyl)-2-pyron, 2-Trichlormethylbenzimidazol, 2-Tribrommethylchinolin, 2,4-Dimethyl-1-tribromacetyl-benzol, 3-Nitro-1-tribromacetyl-benzol, 4-Dibromacetyl-benzoesäure, 1,4-Bis-dibrommethyl-benzol, Tris-dibrommethyl-s-triazin, 2-(6-Methoxy-naphth-2-yl)-, 2-(Naphth-1-yl)-, 2-(4-Ethoxy-ethylnaphth-1-yl)-, 2-(Benzo-pyran-3-yl)-, 2-(4-Methoxyanthrac-1-yl)-, 2-(4-Styrylphenyl)-, 2-(Phenanthr-9-yl)-4,6-bis-trichlormethyl-s-triazin und die in den Beispielen aufgeführten Verbindungen.

Die Menge des photochemischen Säurespenders kann je nach seiner chemischen Natur und der Zusammensetzung der Schicht ebenfalls sehr verschieden sein. Günstige Ergebnisse werden erhalten mit etwa 0,5 bis zu 20 Gewichtsprozent, vorzugsweise 1 bis 12 Gewichtsprozent, bezogen auf den Gesamtfeststoff des Gemisches. Besonders für lichtempfindliche Schichten von Dicken über 0,01 mm empfiehlt es sich, relativ wenig Säurespender zu verwenden.

Als Bindemittel werden Polykondensate oder Polymerisate mit freien phenolischen Hydroxylgruppen eingesetzt, wobei der Gehalt an phenolischen Hydroxylgruppen bevorzugt zwischen 2 und 9 mmol/g Bindemittel liegt. Als Beispiele für Polykondensate sind zu nennen, Phenolharze vom Novolaktyp oder hydroxysubstituierte Aramide. Als Beispiele für Polymerisate seien genannt, Homo- und Copolymerisate von Vinylphenolen (DE-OS 2 322 230, entsprechend US-PS 3 869 292 und DE-OS 3 406 927, entsprechend US-PS 4 678 737), Polymerisate der Ester von Acrylsäuren mit Phenolen (JP-OS 76/36 129 und EP-OS 212 439) oder Gopolymerisate von Hydroxyphenylmaleinimiden (EP-OS 0 187 517). Die Glasübergangstemperaturen dieser Bindemittel variieren je nach Anwendungsbereich. Für Trockenresistanwendungen, wo eine gute Laminierbarkeit gefordert ist, sind Glasübergangstemperaturen $< 100\ ^{\circ}C$ vorteilhaft. Im Falle der

Anwendung im Flachdruck oder in der Fertigung mikro elektronischer Schaltungen sind Glasübergangstemperaturen > 100 °C günstig. Die Menge des Bindemittels beträgt im allgemeinen 20 bis 90, vorzugsweise 50 bis 85 Gewichtsprozent der nichtflüchtigen Bestandteile des Gemisches.

Zusätzlich können noch zahlreiche andere Oligomere und Polymere mitverwendet werden, z.B. Vinylpolymerisate wie Polyvinylacetale, Polymethacrylate, Polyacrylate, Polyvinylether und Polyvinylpyrrolidone, die selbst durch Comonomere modifiziert sein können.

Der günstigste Anteil an diesen Zusätzen richtet sich nach den anwendungstechnischen Erfordernissen und dem Einfluß auf die Entwicklungsbedingungen und beträgt im allgemeinen nicht mehr als 20 Gewichtsprozent vom Bindemittel mit seitenständigen phenolischen Gruppen. In geringen Mengen kann die lichtempfindliche Schicht für spezielle Erfordernisse wie Flexibilitat, Haftung, Glanz etc. außerdem noch Substanzen wie Polyglykole, Celluloseether, z.B. Ethylcellulose, Netzmittel und feinteilige Pigmente enthalten.

Ferner können dem lichtempfindlichen Gemisch noch lösliche oder auch feinteilige dispergierbare Farbstoffe sowie, je nach Anwendungszweck, auch UV-Absorber zugesetzt werden. Gemische aus Basis von 1,2-Chinondiaziden, welche einen breiten Spielraum bei der Positiv-Negativ-Konversion besitzen sollen, enthalten weiterhin eine basische Komponente, die befähigt ist, mit der bei der Bestrahlung entstehenden Carbonsäure ein Salz zu bilden.

Die Erfindung betrifft auch ein strahlungsempfindliches Kopiermaterial aus einem Schichtträger und einem aufgebrachten strahlungsempfindlichen Gemisch nach Ansprüchen 1 bis 9.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methylethylketon, chlorierte Kohlenwasserstoffe, wie Trichlorethylen und 1,1,1-Trichlorethan, Alkohole wie n-Propanol, Ether wie Tetrahydrofuran, Alkoholether wie Ethylenglykolmonoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether und Propylenglykolmonomethylether allein oder im Gemisch werden besonders bevorzugt.

Als Schichtträger für Schichtdicken unter ca. 10 µm werden meist Metalle verwendet. Für Offsetdruckplatten können eingesetzt werden: walzblankes, mechanisch und/oder elektrochemisch aufgerauhtes und gegebenenfalls anodi siertes Aluminium, das zudem noch chemisch, z.B. mit Polyvinylphosphonsäure, Silikaten, Phosphaten, Hexafluorozirkonaten oder mit hydrolysiertem Tetraethylorthosilikat vorbehandelt sein kann.

Die Beschichtung des Schichtträgers erfolgt in bekannter Weise durch Aufschleudern, Sprühen, Tauchen, Walzen mittels Breitschlitzdüsen, Rakeln oder durch Gießer-Antrag.

Zum Belichten können die üblichen Lichtquellen wie Röhrenlampen, Xenonimpulslampen, metallhalogeniddotierte Quecksilberdampf-Hochdrucklampen und Kohlenbogenlampen verwendet werden.

Unter Belichtung bzw. Bestrahlung ist in dieser Beschreibung die Einwirkung aktinischer elektromagnetischer Strahlung in Wellenlängenbereichen unterhalb etwa 500 nm zu verstehen. Alle in diesem Wellenlängenbereich emittierenden Strahlungsquellen sind prinzipiell geeignet.

Mit Vorteil können auch Laserbestrahlungsgeräte, insbesondere automatische Verarbeitungsanlagen verwendet werden, die als Strahlungsquelle z.B. einen Argon- oder Krypton-Ionen-Laser enthalten.

Die Bestrahlung kann auch mit Elektronenstrahlen erfolgen. Auch Röntgenstrahlen können zur Bilderezugung verwendet werden.

Die bildmäßig belichtete oder bestrahlte Schicht kann in bekannter Weise mit praktisch den gleichen Entwicklern, wie sie für handelsübliche Naphthochinondiazid-Schichten und Kopierlacke bekannt sind, entfernt werden, oder die erfindungsgemäßen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können z.B. Alkaliphosphate, -silikate oder -hydroxide und ferner Netzmittel sowie gegebenenfalls kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Bei der Anwendung als Druckplatten können zur Erhöhung der Widerstandsfähigkeit beim Druck sowie der Resistenz gegen Auswaschmittel, Korrekturmittel und durch UV-Licht härtbare Druckfarben die entwikkelten Platten kurzzeitig auf erhöhte Temperaturen erwärmt werden, wie es für Diazoschichten aus der GB-PS 1 154 749 bekannt ist.

Im folgenden werden Beispiele für bevorzugte Ausführungsformen angegeben. In den Beispielen stehen Gewichtsteile (Gt) und Volumenteile (Vt) im Verhältnis von g zu ccm. Prozent- und Mengenverhältnisse sind, wenn nichts anderes angegeben ist, in Gewichtseinheiten zu verstehen.

Beispiel 1

Auf eine in Salzsäure aufgerauhte, in Schwefelsäure anodisierte und mit Polyvinylphosphonsäure hydrophilierte Aluminiumfolie wird eine Lösung schleuderbeschichtet, welche sich nach EP-OS 0 212 482 zur Umkehrverarbeitung eignet:

1,6 Gt eines Veresterungsproduktes aus 3 Mol 1,2-Naphthochinon-(2)-diazid-4-sulfonylchlorid und 2,3,4-Trihydroxybenzophenon,

8,0 Gt eines m-Kresol-Formaldehyd-Novolaks mit einer Hydroxylzahl von 320 und einem Gewichtsmittelwert von 6000

0,8 Gt 2,6-Bis-hydroxymethyl-4-methyl-phenol

0,05 Gt 2-(4-Styrylphenyl)-4,6-bis-trichlormethyl-s-triazin

0,1 Gt Farbstoff, siehe Tabelle 1

100 Gt eines Lösungsmittelgemisches aus Tetrahydrofuran und Propylenglykolmonomethylether (55 : 45).

Nach 2-minütigem Trocknen bei 100 °C resultiert eine Schichtdicke von 2 µm.

Die Druckplatten werden unter einer 5-kW-Metallhalogenidlampe im Abstand von 110 cm durch einen Halbtonstufenkeil mit 13 Dichtestufen von je 0,15 (Belichtungskeil "BK 01" der Hoechst AG) 60 Sekunden lang belichtet, darauf 2 Minuten auf 125 °C erhitzt, anschließend 40 Sekunden ohne Vorlage belichtet und in folgendem Entwickler 60 Sekunden entwickelt:

8,5 Gt $Na_2SiO_3$ x 9 $H_2O$,

0,8 Gt NaOH und

1,5 Gt $Na_2B_4O_7$ x 10 $H_2O$ in 89,2 Gt $H_2O$

Man erhält in allen Fällen negative Abbilder der Vorlage. Tabelle 2 gibt die Ergebnisse im einzelnen wieder, wobei die Beurteilung des Kontrasts visuell vorgenommmen und folgendermaßen bewertet wurde:

+ gut erkenntlicher Kontrast zwischen belichteten und unbelichteten Beeichen

o noch erkennbarer Kontrast zwischen belichteten und unbelichteten Bereichen

- den praktischen Anforderungen nicht mehr genügender Kontrast zwischen belichteten und unbelichteten Bereichen.

Tabelle 1:

| Farbstoff Nr. | Bezeichnung |
|---|---|
| 1 | 5′-Chlor-1′,3′,3′-trimethyl-6-nitro-8-methoxy-spiro-[2H-1-benzopyran-2,2′-indolin] |
| 2 | 1′,3′,3′-Trimethyl-6-nitro-spiro-[2H-1-benzopyran-2,2′-indolin] |
| 3 | 1′,3′,3′-Trimethyl-6-nitro-8-methoxy-spiro-[2H-1-benzopyran-2,2′-indolin] |
| 4 (Vergleich) | Kristallviolett (C.I. 42555) |
| 5 (Vergleich) | Victoriareinblau (C.I. 42595) |
| 6 (Vergleich) | Astrazonrotviolett 3RN (C.I. 48013) |
| 7 (Vergleich) | Sudangelb GGN (C.I. 11021) |

Weiterhin ist in Tabelle 2 festgehalten, welche offene Stufe sich ergibt, wenn nach der bildmäßigen Belichtung von 60 Sekunden gleich entwickelt wird, also eine Positivverarbeitung durchgeführt wird.

Tabelle 2:

| Bsp. Nr. | Farbstoff Nr. | Farbumschlag | Bildkontrast vor nach Erwärmung | | voll gedeckte Stufe (Neg.verarb.) | offene Stufe (Pos.verarb.) |
|---|---|---|---|---|---|---|
| | | | vor | nach | | |
| | | | Erwärmung | | | |
| 1-1 | 1 | blauviolett→ gelbgrün | + | + | 3 | 3 |
| 1-2 | 2 | blauviolett→ gelbgrün | + | + | 3 | 3 |
| 1-3 | 3 | blauviolett→ gelbgrün | + | + | 3 | 3 |
| 1-4 | 4 (Vgl.) | blauviolett→ gelbgrün | + | - | 3 | 3 |
| 1-5 | 5 (Vgl.) | grün → gelbgrün | + | - | 3 | 3 |
| 1-6 | 6 (Vgl.) | rot→hellrot | + | o | 3 | 3 |
| 1-7 | 7 (Vgl.) | gelb→braun | + | o | 2 | 1 |

Diese Ergebnisse zeigen, daß mit den erfindungsgemäßen Spiro-indolino-benzopyranen ausgezeichnete Bildkontraste von hervorragender thermischer Stabilität erhalten werden.

Beispiel 2

Es werden Beschichtungslösungen hergestellt aus:
5,0 Gt Bindemittel (vgl. Tabelle 3)
1,4 Gt eines oligomeren Acetals, welches durch Polykondensation von Triethylenglykol und 2-Ethylbutyraldehyd erhalten wurde, Hydroxylzahl 140
0,2 Gt 2-(4-Styrylphenyl)-4,6-bis-trichlormethyl-s-triazin
Gt Farbstoff (vgl. Tabelle 4)
100 Gt des Lösungsmittelgemisches aus Beispiel 1

Diese Lösungen werden auf Aluminiumplatten, die wie in Beispiel 1 vorbehandelt wurden, aufgeschleudert. Nach 2-minütiger Trocknung bei 100 °C resultiert eine Schichtdicke von 2,5 µm. Auf diese Kopierschicht wird dann eine nicht lichtempfindliche Deckschicht aus Polyvinylalkoholen (K-Wert 4, Restacetylgruppengehalt 12 %) entsprechend DE-OS 3 715 790 aus Wasser in einer Stärke von 0,2 µm aufgebracht.

Tabelle 3:

| Bindemittel Nr. | Zusammensetzung | Hydroxylzahl | Gewichtsmittelwert (GPC) |
|---|---|---|---|
| 1 | m-Kresol-Fomaldehyd-Novolak | 320 | 6000 |
| 2 | Copolymer (45:55) aus 4-Hydroxystyrol und Methylmethacrylat | 230 | 20000 |
| 3 | Copolymer (70:30) aus 2-hydroxyphenylmethacrylat u. Styrol | 240 | 20000 |
| 4 | Copolymer (75:25) aus 3,5-Dimethyl-4-hydroxybenzylmethacrylamid und Styrol | 225 | 15000 |

Tabelle 4:

| Farbstoff Nr. | Menge [Gt] | Bezeichnung |
|---|---|---|
| 3 | 0,03 | 1′,3′,3′-Trimethyl-6-nitro-8-methoxy-spiro-[2H-1-benzopyran-2,2′-indolin] |
| 8 (Vgl.) | 0,05 | Säureviolett 520 PINA[R], Antihalofarbstoff von Riedel de Haen, Art-Nr. 28587 |
| 9 (Vgl.) | 0,05 | Säureviolett 520 T PINA[R], Art-Nr. 28579 |
| 10 (Vgl.) | 0,02 | Kristallviolett-Base |

Farbstoffe Nr. 8 und 9 zählen zur Klasse der in DE-OS 3 541 534 beschriebenen Hemioxonolfarbstoffe.

Die Druckplatten werden unter einer Vorlage wie in Beispiel 1 beschrieben 20 Sekunden lang belichtet, anschließend für 1 Minute auf 80 °C erhitzt zur Vervollständigung der Acetalhydrolyse und dann im Entwickler aus Beispiel 1 1 Minute lang entwickelt. In Tabelle 5 sind die Ergebnisse festgehalten. Der Belichtungskontrast wurde wie in Beispiel 1 beurteilt. Zur Prüfung der Lagerstabilität wurden die Platten längere Zeit bei 100 °C gelagert und das Entwicklungsverhalten in Intervallen von 1 Stunde untersucht. Nach 6 Stunden wurde die Prüfung abgebrochen.

Die Ergebnisse zeigen, daß die Hemioxonolfarbstoffe zwar eine ähnlich gute Kontraststabilität ergeben wie die erfindungsgemäßen Spiroindolinobenzopyrane, jedoch die Lagerstabilität der Kopierschicht ganz erheblich beeinträchtigen.

Tabelle 5

| Beispiel Nr. | Farbstoff Nr. | Bindemittel Nr. | Farbumschlag | Bildkontrast | | offene Stufe | Lagerstabilität [Stunden] |
|---|---|---|---|---|---|---|---|
| | | | | vor | nach | | |
| | | | | Erwärmung | | | |
| 2-1 | 3 | 1 | blauviolett → gelbgrün | + | + | 3 | > 6 |
| 2-2 | 8 (Vgl.) | 1 | violett → hellrot | + | + | 4 | < 1 |
| 2-3 | 9 (Vgl.) | 1 | violett → hellrot | + | + | 4 | 1 |
| 2-4 | 10 (Vgl.) | 1 | blau → gelbgrün | + | - | 3 | > 6 |
| 2-5 | 3 | 3 | blauviolett → gelbgrün | + | + | 3 | > 6 |
| 2-6 | 8 (Vgl.) | 3 | violett → hellrot | + | + | 4 | < 1 |
| 2-7 | 9 (Vgl.) | 3 | violett → hellrot | + | + | 4 | 1 |
| 2-8 | 10 (Vgl.) | 3 | blau → gelbgrün | + | - | 3 | > 6 |
| 2-9 | 3 | 2 | blauviolett → gelbgrün | + | + | 3 | > 6 |
| 2-10 | 3 | 4 | blauviolett → gelbgrün | + | + | 3 | > 6 |

Beispiel 3

Es werden Beschichtungslösungen hergestellt aus:
8,0 Gt des Bindemitteles aus Beispiel 1
1,6 Gt eines Veresterungsproduktes aus 1 Mol 1,2-Naphthochinondiazid-4-sulfonylchlorid und 1 Mol p-Cumylphenol
X Gt 2,4-Diethoxy-6-diethylamino-s-triazin, entsprechend DE-A 3 711 263 als Base, Menge siehe Tabelle 6
X Gt 2-(4-Styrylphenyl)-4,6-bis-trichlormethyl-s-triazin als Säurebildner, Menge vgl. Tabelle 6
X Gt Farbstoff, vergleiche Tabelle 6
100 Gt des Lösungsmittelgemisches aus Beispiel 1

Diese Lösungen werden auf Aluminiumplatten, die wie in Beispiel 1 behandelt wurden, aufgeschleudert. Nach 2-minütiger Trocknung bei 100 °C resultiert eine Schichtdicke von 2 µm.

Die Druckplatten wurden unter einer Vorlage wie in Beispiel 1 60 Sekunden belichtet, 2 Minuten bei verschiedenen Temperaturen gelagert, 40 Sekunden ohne Vorlage belichtet und wie in Beispiel 1 entwikkelt.

Die Ergebnisse sind in Tabelle 6 festgehalten, wobei die Kontraststabilität wie in Beispiel 1 beurteilt wurde. Unter Temperaturspielraum ist der Temperaturbereich auf geführt, innerhalb dessen eine Positiv-Negativ-Konversion bei einer Konversionszeit von 2 Minuten möglich ist.

Die Beispiele 3-2 und 3-3 zeigen, daß sich durch Zusatz der Spiroindolinobenzopyrane in Mengen, wie sie für Basenzusätze zur Erreichung eines günstigen Konversionsverhaltens beschrieben sind, ebenfalls ein breiter Temperaturspielraum ergibt.

Tabelle 6:

| Beispiel Nr. | Base [Gt] | Säurebildner [Gt] | Farbstoff Nr. [Gt] | Farbumschlag | Bildkontrast | | Temperaturspielraum [°C] |
|---|---|---|---|---|---|---|---|
| | | | | | vor | nach | |
| | | | | | Erwärmung | | |
| 3-1 (Vgl.) | - | - | - | gelb → gelborange | - | - | 135 - 145 |
| 3-2 | - | - | 2 (0,4) | violett → grün | + | + | 95 145 |
| 3-3 | - | - | 3 (0,4) | violett → grün | + | + | 95 145 |
| 3-4 | 0,4 | - | 3 (0,1) | blauviolett → gelbgrün | + | + | 90 145 |
| 3-5 | 0,4 | 0,05 | 3 (0,1) | blauviolett → gelbgrün | + | + | 95 145 |
| 3-6 (Vgl.) | 0,4 | - | 5 (0,1) | grün → grün | - | - | 90 145 |
| 3-7 (Vgl.) | 0,4 | 0,05 | 5 (0,1) | grün → grün | - | - | 95 145 |
| 3-8 | 0,4 | - | 3 (0,05) +5 (0,05) | blau → gelbgrün | + | + | 90 145 |
| 3-9 (Vgl.) | 0,4 | - | 7 (0,05) +5 (0,05) | blau → gelbgrün | + | o | 90 145 |

Beispiel 4

Es werden Beschichtungslösungen hergestellt aus:

5,0 Gt eines Gemisches der polymeren Bindemittel Nr.1 und 3 aus Tabelle 3 im Verhältnis 1:1

0,5 Gt eines Veresterungsproduktes aus 3 Mol 1,2-Naphthochinon-2-diazid-4-sulfonylchlorid und 1 Mol 2,3,4-Trihydroxybenzophenon

1,2 Gt des oligomeren Acetals aus Beispiel 2

0,15 Gt 2-(4-Styrylphenyl)-4,6-bis-trichlormethyl-s-triazin

X Gt Farbstoff, vgl. Tabelle 7

100 Gt des Lösungsmittelgemisches aus Beispiel 1

Diese Lösungen werden auf Aluminiumplatten, die wie in Beispiel 1 beschrieben, vorbehandelt wurden, beschichtet, so daß nach 2-minütiger Trocknung bei 100 °C eine Schichtdicke von 2000nm vorliegt. Auf diese Kopierschicht wird eine Deckschicht aus Polyvinylalkohol, wie in Beispiel 2, aufgebracht.

Die Platten werden unter einem Halbtonstufenkeil und einer Rastervorlage (60-er Raster), wie in Beispiel 1, 30 Sekunden lang belichtet und nach einminütiger Erwärmung auf 80 °C im Entwickler aus Beispiel 1 eine Minute entwickelt.

Tabelle 7 gibt die Ergebnisse wieder.

Tabelle 7:

| Bsp. Nr. | Farbstoff Nr. | Farbumschlag | Bildkontrast | | offene Stufe im Halbtonstufenkeil | Rasterwiedergabe |
|---|---|---|---|---|---|---|
| | | | vor | nach | | |
| | | | Erwärmung | | | |
| 4-1 | 3 (0,06) | blauviolett → gelbgrün | + | + | 4 | 2% fast vollständig |
| 4-2 | 10 (0,04) | blauviolett → gelbgrün | + | - | 4 | 2 % nur teilweise |

Zur Beurteilung des Einbrennverhaltens der Platten werden diese 5 Minuten auf 230 °C erhitzt und dann auf Chemikalienresistenz und Druckauflage geprüft. Tabelle 8 gibt die Ergebnisse wieder.

Tabelle 8:

| Bsp. Nr. | Farbumschlag beim Einbrennen | Schichtresistenz gegen Dimethylformamid | Druckauflage in einer Bogenoffsetmaschine | |
|---|---|---|---|---|
| | | | uneingebrannt | eingebrannt |
| 4-1 | blauviolett → gelbbraun | + | 80.000 | 300.000 |
| 4-2 | blauviolett → gelbbraun | + | 80.000 | 300.000 |

Diese Beispiele zeigen, daß die erfindungsgemäßen Spiroindolino-benzopyrane das Wiedergabverhalten günstig beeinflußen und den Einbrennvorgang durch Farbumschlag indizieren.

## Ansprüche

1. Strahlungsempfindliches Gemisch, das als wesentliche Bestandteile

A) ein 1,2-Chinondiazid und/oder eine Kombination aus

1. einer unter Einwirkung von aktinischer Strahlung starke Säure bildende Verbindung und

2. einer Verbindung mit mindestens einer spaltbaren C-O-C-Bindung enthält, deren Löslichkeit in einem

flüssigen Entwickler durch Einwirkung von Säure erhöht wird, und

B) ein in Wasser unlösliches, in wäßrig-alkalischen Lösungen lösliches polymeres Bindemittel und

C) einen Farbstoff enthält, dadurch gekennzeichnet, daß es als Farbstoff ein Spiroindolino-benzopyran der allgemeinen Formel I

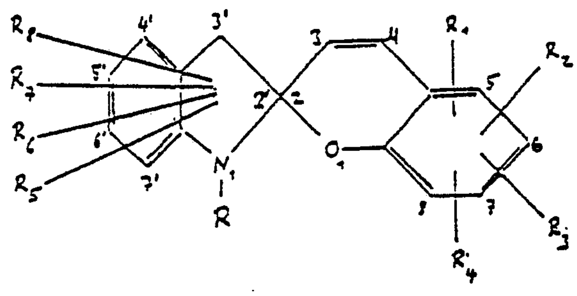

enthält, worin

R ein Wasserstoff oder einen Alkylrest mit 1 bis 16 Kohlenstoffatomen,

$R_1$, $R_2$, $R_3$, $R_4$ gleich oder verschieden sind und Wasserstoff- oder Halogenatome, Alkyl- oder Alkoxygruppen mit 1 bis 4 Kohlenstoffatomen, Hydroxy- oder Nitrogruppen, und

$R_5$, $R_6$, $R_7$ und $R_8$ gleich oder verschieden sind und Wasserstoff-oder Halogenatome, Nitro-, Aminogruppen, Alkyl-, Alkoxy- oder Hydroxyalkylgruppen mit 1 bis 5 Kohlenstoffatomen oder Arylgruppen mit 6 bis 10 Kohlenstoffatomen

bedeuten.

2. Gemisch nach Anspruch 1, dadurch gekennzeichnet, daß es eine Verbindung der Formel I enthält, worin mindestens einer der Reste $R_1$ $R_2$, $R_3$ und $R_4$ eine Nitrogruppe ist.

3. Gemisch nach Anspruch 1, dadurch gekennzeichnet, daß es eine Verbindung der Formel I enthält, worin drei der Reste R, $R_5$, $R_6$ , $R_7$ und $R_8$ Methylgruppen sind.

4. Gemisch nach Anspruch 1, dadurch gekennzeichnet, daß es 0,01 bis 10 Gewichtsprozent der Verbindung der Formel I, bezogen auf Gesamtfeststoff, enthält.

5. Gemisch nach Anspruch 1, dadurch gekennzeichnet, daß es zusätzlich einen kationischen Farbstoff enthält.

6. Gemisch nach Ansprüchen 1 und 5, dadurch gekennzeichnet, daß der kationische Farbstoff ein Triarylmethan-, Acridin-, Azin-, Oxazin-, Thiazin- oder Cyaninfarbstoff ist.

7. Strahlungsempfindliches Gemisch nach Anspruch 5, dadurch gekennzeichnet, daß die Menge des kationischen Farbstoffs 0,01 bis 10 Gewichtsprozent, bezogen auf den Gesamtfeststoff, beträgt.

8. Strahlungsempfindliches Gemisch nach Anspruch 1, dadurch gekennzeichnet, daß die 1,2-Chinondiazidverbindung ein 1,2-Naphthochinon-2-diazid-4- oder -5-sulfonsäureester oder -amid ist.

9. Strahlungsempfindliches Gemisch nach Anspruch 1, dadurch gekennzeichnet, daß die Verbindung mit mindestens einer durch Säure spaltbaren C-O-C-Bindung eine Oligomer-oder Polymerverbindung mit wiederkehrenden Acetal- und/oder Ketalgruppierungen in der Hauptkette ist.

10. Strahlungempfindliches Kopiermaterial aus einem Schichtträger und einem aufgebrachten strahlungsempfindlichen Gemisch nach Ansprüchen 1 bis 9.